(19) Europäisches Patentamt
European Patent Office
Office européen des brevets

(11) **EP 4 177 383 A1**

(12) **EUROPEAN PATENT APPLICATION**
published in accordance with Art. 153(4) EPC

(43) Date of publication:
**10.05.2023 Bulletin 2023/19**

(21) Application number: **21833771.5**

(22) Date of filing: **26.03.2021**

(51) International Patent Classification (IPC):
**C30B 29/28** [(2006.01)] **C30B 19/04** [(2006.01)]
**G02B 27/28** [(2006.01)]

(52) Cooperative Patent Classification (CPC):
**C30B 19/04; C30B 29/28; G02B 27/28**

(86) International application number:
**PCT/JP2021/012963**

(87) International publication number:
**WO 2022/004077 (06.01.2022 Gazette 2022/01)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **03.07.2020 JP 2020115646**

(71) Applicant: **SHIN-ETSU CHEMICAL CO., LTD.
Tokyo 1000005 (JP)**

(72) Inventors:
• **WATANABE, Toshiaki
Annaka-shi, Gunma 379-0195 (JP)**
• **FUKUDA, Satoru
Annaka-shi, Gunma 379-0195 (JP)**

(74) Representative: **Vossius & Partner
Patentanwälte Rechtsanwälte mbB
Siebertstraße 3
81675 München (DE)**

(54) **BISMUTH-SUBSTITUTED RARE EARTH IRON GARNET SINGLE CRYSTAL FILM PRODUCTION METHOD, FARADAY ROTATOR, AND OPTICAL ISOLATOR**

(57) A bismuth-substituted rare earth iron garnet single crystal film production method that is resistant to cracking, etc., is provided.

In the bismuth-substituted rare earth iron garnet single crystal film production method according to the present invention, the bismuth-substituted rare earth iron garnet single crystal film expressed by the composition formula $(Ln_{3-a}Bi_a)(Fe_{5-b}A_b)O_{12}$ is grown using a substrate of paramagnetic garnet with a lattice constant of Ls. The bismuth-substituted rare earth iron garnet single crystal film production method comprises a step of forming a buffer layer with an average lattice constant of Lb (where Lb > Ls) on the surface of the substrate with a thickness of 5 to 30 $\mu$m, and a step of growing a target bismuth-substituted rare earth iron garnet crystal film with an average lattice constant of Lf (where Lf > Lb) with a thickness of 100 um or more overlaid on the buffer layer. The rate of lattice constant change in the buffer layer is steeper than the rate of lattice constant change in the bismuth-substituted rare earth iron garnet crystal film. In the composition formula, Ln is selected from Y, elements selected from lanthanides (La, Ce, Pr, Nd, Sm, Eu, Gd, Tb, Dy, Ho, Er, Tm, Yb, and Lu), and trace elements selected from Ca, Mg, Zr, and Hf, and A is one or more elements selected from Al, Ga, In, Sc, Ti, Si, Ge, and Sn.

FIG. 1

## Description

Technical Field

The present invention relates to an optical isolator used in opto-processing and optical measurement and a crystal for a Faraday rotator used therein.

Background Art

In a laser light source used in an opto-processing machine or an optical measuring machine, the laser oscillation becomes unstable when the emitted laser light is reflected on a surface of a material provided in the propagation path, and the reflected light returns to the laser light source. In order to block such reflected and returned light, an optical isolator using a Faraday rotator which non-reciprocally rotates the polarization plane is used.

Conventionally, as materials for a magneto-optical element such as an optical isolator, a bismuth-substituted rare earth iron garnet crystal grown on a substrate crystal by the liquid phase epitaxial method is used (see, for example, Patent Document 1). The composition of the garnet crystal film is highly constrained by the lattice constant of the base substrate.

In fact, 45deg Faraday rotators for optical isolators used in optical communications at optical wavelengths such as 1310nm and 1550nm require a thickness of 250 to 600$\mu$m, and the crystal film of 350 to 700$\mu$m must be grown if the polishing allowance of the crystal film is taken into account. Factors such as the chemical composition, film thickness, and thermal expansion coefficient of the substrate and target garnet film affect the growth of crystal films. It is difficult to obtain a good quality single crystal thick film simply by matching lattice constants, and if the conditions for growing crystal films are not appropriate, cracks or other problems will occur during thick film growth.

Prior Art References

Patent Documents

Patent Document 1:JP2000-347135A

Summary of the Invention

Problems to be solved by the Invention

The present invention was made in view of the above circumstances, and it is an object to provide a bismuth-substituted rare earth iron garnet single crystal film production method that is less likely to crack and the like

Means for Solving the Problems

To solve the above problem, the bismuth-substituted rare earth iron garnet single crystal film production method according to an embodiment of the present invention is to grow the bismuth-substituted rare earth iron garnet single crystal film expressed by the composition formula $(Ln_{3-a}Bi_a)(Fe_{5-b}A_b)O_{12}$ using a substrate of paramagnetic garnet with a lattice constant of Ls. The bismuth-substituted rare earth iron garnet single crystal film production method comprises a step of forming a buffer layer with an average lattice constant of Lb (where Lb > Ls) on the surface of the substrate with a thickness of 5 to 30 $\mu$m, and a step of growing a target bismuth-substituted rare earth iron garnet crystal film with an average lattice constant of Lf (where Lf > Lb) with a thickness of 100 $\mu$m or more overlaid on the buffer layer. In the present invention, the rate of lattice constant change in the buffer layer is steeper than the rate of lattice constant change in the bismuth-substituted rare earth iron garnet crystal film. The rate of lattice constant change in the buffer layer may be $10 \times 10^{-4}\%/\mu$m or more, and the rate of lattice constant change in the bismuth-substituted rare earth iron garnet crystal film may be $2.0 \times 10^{-4}\%/\mu$m or less.

In the present invention, Lb-Ls may be +0.001 to +0.005 Å, and Lf-Ls may be +0.005 to +0.015 Å at room temperature. In the present invention, the rate of lattice constant change in the buffer layer may be $10 \times 10^{-4}\%/\mu$m or more. In the present invention, the crystal growth may be performed with a PbO-free melt composition.

A Faraday rotator according to the present invention is characterized in that it is obtained from the bismuth-substituted rare earth iron garnet single crystal film produced by any of the above methods by polishing and removing the buffer layer. The optical isolator is characterized in that it is composed of the Faraday rotator described above.

Effects of Invention

According to the production method of the present invention, when a garnet single crystal film is deposited on a substrate by the liquid-phase epitaxial method, stress generation in the target single crystal layer can be reduced, and cracking can be prevented.

Brief Description of the Drawings

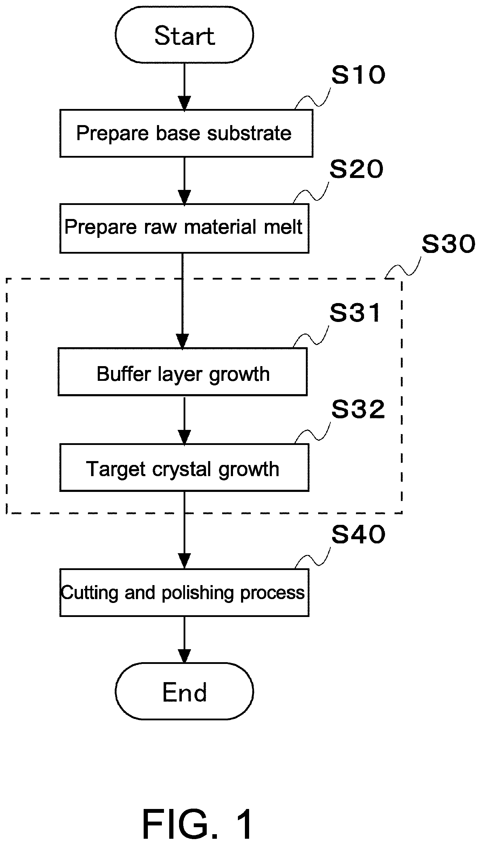

Fig. 1 shows a flowchart of the production method for a bismuth-substituted rare earth iron garnet single crystal.

Description of Embodiments

Hereinafter, embodiments of the present invention will be described in detail, but the present invention is not limited thereto.

In this embodiment, in growing single crystal film, especially bismuth-substituted rare earth iron garnet crystal, by epitaxial method on a crystal substrate, a buffer layer with a large rate of lattice constant change is initially formed on the substrate surface, and then the target garnet film is grown with a low rate of lattice constant change. By forming the buffer layer, it is possible to reduce the occurrence of cracks and other problems during thick film growth. Details are described below.

<Composition of bismuth-substituted rare earth iron garnet single crystal>

The bismuth-substituted rare earth iron garnet single crystal produced by the production method of the present embodiment will be described. This bismuth-substituted rare earth iron garnet single crystal is suitable for use in a Faraday rotator and an optical isolator. The bismuth-substituted rare earth iron garnet single crystal is represented by the following compositional formula (1).

$$(Ln_{3-a}Bi_a)(Fe_{5-b}A_b)O_{12} \quad ... (1)$$

In the composition formula (1), Ln is one or more elements selected from Y, lanthanides (La, Ce, Pr, Nd, Sm, Eu, Gd, Tb, Dy, Ho, Er, Tm, Yb, Lu), and trace elements such as Ca, Mg, Zr. Multiple of these elements may be used as Ln simultaneously. A is selected from Al, Ga, In, Sc, and Hf or trace elements such as Ti, Si, Ge, and Sn. Multiple of these elements may be used as A simultaneously.

<Production method of bismuth-substituted rare earth iron garnet single crystal>

The bismuth-substituted rare earth iron garnet single crystal of the present invention may be grown with a PbO-free melt composition. A specific example of the production method of bismuth-substituted rare earth iron garnet single crystal is explained below with reference to the flowchart shown in Fig. 1.

First, a substrate used as a base for the growth of bismuth-substituted rare earth iron garnet single crystal is prepared (Step S10). The substrate to be prepared may be a paramagnetic garnet substrate with a lattice constant of Ls. Specifically, for example, a $Gd_3Ga_5O_{12}$ (GGG; gadolinium, gallium, garnet) single crystal substrate with Ca, Mg, Zr, Y, etc. added (NOG: Shin-Etsu Chemical trademark, SGGG: Saint-Gobain trademark) may be used. By using such a substrate, a single crystal can be pulled up and obtained by liquid-phase epitaxy.

Next, the metal oxide that will be the raw material for the bismuth-substituted rare earth iron garnet single crystal is melted in a platinum crucible to prepare the raw material melt (Step S20). The raw metal oxides include, for example, $Gd_2O_3$, $Ho_2O_3$, $Bi_2O_3$, $Fe_2O_3$,

$Ga_2O_3$, $TiO_2$, and MgO. The raw material melt is prepared by preparing these metal oxides in predetermined molar weight ratios, putting them in the platinum crucible, and heating and melting them at a predetermined temperature.

Then, a single crystal film is grown by the liquid-phase epitaxy in which the substrate is brought in contact with the prepared raw material melt and pulling it up (Step S30). In the liquid-phase epitaxy method, the growth temperature is gradually lowered to continuously separate a single crystal film on the substrate surface. In the present embodiment, the buffer layer is formed by a short time and large temperature drop width in the early stages of growth (Step S31). The average lattice constant Lb of the buffer layer is larger than the average lattice constant Ls of the base substrate, and the thickness of the buffer layer is preferably 5 to 30 $\mu$m. Then, the target crystal (garnet crystal film) is grown by a gradual temperature drop over a long period of time (Step S32). Thereby, a garnet crystal film is formed overlaid on the buffer layer. The average lattice constant Lf of the garnet crystal film is larger than the average lattice constant Lb of the buffer layer, and the thickness of the garnet crystal film may be more than 100 um. The rate of lattice constant change (the amount of change in lattice constant per unit length in the thickness direction) in the buffer layer is steeper than the rate of lattice constant change in the garnet crystal film. The rate of lattice constant change in the buffer layer may be $10 \times 10^{-4}\%/\mu m$ or more, and the rate of lattice constant change in the bismuth-substituted rare earth iron garnet crystal film may be $2.0 \times 10^{-4}\%/\mu m$ or less.

The grown single crystal film is then cut and polished (i.e., the buffer layer and substrate are removed from the bismuth-substituted rare earth iron garnet single crystal film) to obtain the bismuth-substituted rare earth iron garnet single crystal that can be used for a Faraday rotator and an optical isolator (Step S40). The Faraday rotator can be configured using the bismuth-substituted rare earth iron garnet single crystal thus obtained. Furthermore, the optical isolator can be configured using the Faraday rotator.

[EXAMPLES]

[Example 1]

$Gd_2O_3$, $Ho_2O_3$, $Fe_2O_3$, and $Ga_2O_3$ with $Bi_2O_3$ added as a flux were melt heated at 1080°C in a platinum crucible, and then the temperature was lowered to 815°C. The weight (melt composition) of the raw materials to be melted were $Gd_2O_3$: 68 g, $Ho_2O_3$: 72.8 g, $Fe_2O_3$: 520.8 g, $Ga_2O_3$: 17.4 g, and $Bi_2O_3$: 7800 g, respectively.

A 3-inch NOG substrate with a lattice constant of 12.498 Å was immersed in the melt to start crystal growth, and the temperature was further rapidly lowered by a temperature range of 4 °C in 1 hour, and then the substrate was brought out of the melt. By this rapid temperature drop, a buffer layer was formed. The crystal film of the buffer layer was 10 um, and the lattice constant of the film surface was 12.502 Å (the average lattice constant was 12.500 Å). For the thickness direction (perpendicular to the substrate surface), the rate of change of the lattice constant was $32.0 \times 10^{-4}$ %/$\mu$m.

The substrate surface/crystal growth surface of the grown crystals was polished, and each substrate surface/crystal growth surface was coated with an antireflective coating against air. Measured using a 1550-nm laser source, the insertion loss was 0.08 dB, and when the effect of reflection at the substrate-crystal interface was removed by calculation, the insertion loss was 0.04 dB. This was a significant insertion loss per unit length. Since the buffer layer has a high loss, it is practical to use a Faraday rotor with the buffer layer polished off, which is required for low insertion loss.

The same initial melt composition as above was melt heated to 1080°C, and then the temperature was lowered to 815°C. A 3-inch NOG substrate with a lattice constant of 12.498 Å was immersed in the melt to start crystal growth, and the temperature was further rapidly lowered by 4 °C in 1 hour. The temperature was then gradually lowered by 10 °C for 40 hours to allow the crystal to grow. The total thickness of the crystal grown in this way was 610 $\mu$m, and the thickness excluding the buffer layer was 600 um. The lattice constant of the film surface was 12.510 Å (the average lattice constant was 12.506 Å). For the thickness direction (perpendicular to the substrate surface), the rate of change of the lattice constant was $1.6 \times 10^{-4}$ %/$\mu$m. No cracking occurred until the film grew to this thickness.

The substrate and buffer layer were then polished and removed from the grown crystal. The crystal growth surface was then polished to 440 $\mu$ m, corresponding to the Faraday rotation angle of 45deg. Both sides of the polished crystal were coated with antireflective coatings against air. The Faraday rotor thus obtained was measured using a 1550-nm laser light source, and the insertion loss was found to be 0.02 dB, which is a loss without practical problems.

[Comparative Example 1]

The initial melt composition as in Example 1 was melt heated to 1080°C, and then the temperature was lowered to 815°C. A 3-inch NOG substrate with a lattice constant of 12.498 Å was immersed in the melt, and the crystal was grown by gradually lowering the temperature by 14°C for 42 hours from start to finish. The total thickness of the crystal grown in this way was 625 um. The lattice constant of the film surface was 12.511 Å (the average lattice constant was 12.507 Å). Cracks were observed at the outer periphery of the substrate in a crystal grown in this way. Cracks were also observed when a crystal with a total growth film thickness of 475 um was grown in a similar manner.

[Example 2]

$Gd_2O_3$, $Y_2O_3$, $Fe_2O_3$, and $Ga_2O_3$ with $Bi_2O_3$ and $B_2O_3$ added as a flux were melt heated at 1080°C in a platinum crucible, and then the temperature was lowered to 812°C. The weight (melt composition) of the raw materials to be melted were $Gd_2O_3$: 22.2 g, $Y_2O_3$: 44.4 g, $Fe_2O_3$: 512.4 g, $Ga_2O_3$: 14.0 g, $Bi_2O_3$: 7820 g, and $B_2O_3$: 14.0 g, respectively.

A 3-inch NOG substrate with a lattice constant of 12.497 Å was immersed in the melt to start crystal growth, and the temperature was further rapidly lowered by a temperature range of 2 °C in 0.5 hours, and then the substrate was brought out of the melt. By this rapid temperature drop, a buffer layer was formed. The crystal film of the buffer layer was 6 um, and the lattice constant of the film surface was 12.498 Å (the average lattice constant was 12.498 Å). For the thickness direction (perpendicular to the substrate surface), the rate of change of the lattice constant was $13.3 \times 10^{-4}$ %/$\mu$m.

The same initial melt composition as above was melt heated to 1080°C, and then the temperature was lowered to 812°C. A 3-inch NOG substrate with a lattice constant of 12.497 Å was immersed in the melt to start crystal growth, and the temperature was further rapidly lowered by 4 °C in 0.5 hours. The temperature was then gradually lowered by 10 °C for 56 hours to allow the crystal to grow. The total thickness of the crystal grown in this way was 575 um, and the thickness excluding the buffer layer was 569 um. The lattice constant of the film surface was 12.511 Å (the average lattice constant was 12.505 Å). For the thickness direction (perpendicular to the substrate surface), the rate of change of the lattice constant was $1.9 \times 10^{-4}$ %/$\mu$m. No cracking occurred until the film grew to this thickness.

[Comparative Example 2]

As in Example 2, the initial melt composition was melt heated to 1080°C, and then the temperature was lowered to 811°C. A 3-inch NOG substrate with a lattice constant of 12.498 Å was immersed in the melt, and the crystal was grown by gradually lowering the temperature by 12°C for 43 hours from start to finish. The total thickness of the crystal grown in this way was 595 um. The lattice constant of the film surface was 12.512 Å (the average lattice constant was 12.505 Å). Cracks were identified in the crystal grown in this way. No cracks were observed when a crystal with a total growth film thickness of 345 $\mu$m was grown in the same way, but cracks were scattered when a crystal with a total growth film thickness of 425 $\mu$m was grown.

[Example 3]

$Eu_2O_3$, $Tb_4O_7$, $Fe_2O_3$, and $Ga_2O_3$ with $Bi_2O_3$ added as a flux were melt heated at 1090°C in a platinum crucible, and then the temperature was lowered to 790°C.

The weight (melt composition) of the raw materials to be melted were $Eu_2O_3$: 21.5 g, $Tb_4O_7$: 174.0 g, $Fe_2O_3$: 525.5 g, $Ga_2O_3$: 24.0 g, and $Bi_2O_3$: 10570 g, respectively.

A 3-inch NOG substrate with a lattice constant of 12.497 Å was immersed in the melt to start crystal growth, and the temperature was further rapidly lowered by a temperature range of 6 °C in 1.5 hours, and then the substrate was brought out of the melt. By this rapid temperature drop, a buffer layer was formed. The crystal film of the buffer layer was 30 $\mu$m, and the lattice constant of the film surface was 12.502 Å (the average lattice constant was 12.500 Å). For the thickness direction (perpendicular to the substrate surface), the rate of change of the lattice constant was $13.3 \times 10^{-4}$ %/$\mu$m.

The same initial melt composition as above was melt heated to 1090°C, and then the temperature was lowered to 790°C. A 3-inch NOG substrate with a lattice constant of 12.497 Å was immersed in the melt to start crystal growth, and the temperature was further rapidly lowered by 6 °C in 1.5 hours. The temperature was then gradually lowered by 12 °C for 39 hours to allow the crystal to grow. The total thickness of the crystal grown in this way was 625 $\mu$m, and the thickness excluding the buffer layer was 595 $\mu$m. The lattice constant of the film surface was 12.512 Å (the average lattice constant was 12.507 Å). For the thickness direction (perpendicular to the substrate surface), the rate of change of the lattice constant was $1.9 \times 10^{-4}$ %/$\mu$m. No cracking occurred until the film grew to this thickness.

[Comparative Example 3]

As in Example 3, the initial melt composition was melt heated to 1090°C, and then the temperature was lowered to 789°C. A 3-inch NOG substrate with a lattice constant of 12.498 Å was immersed in the melt, and the crystal was grown by gradually lowering the temperature by 16°C for 41 hours from start to finish. The total thickness of the crystal grown was 635 $\mu$m. The lattice constant of the film surface was 12.513 Å (the average lattice constant was 12.506 Å). Cracks were identified in the crystal grown in this way. No cracks were observed when a crystal with a total growth film thickness of 345 um was grown in the same way, but cracks were scattered when a crystal with a total growth film thickness of 500 um was grown.

As explained above, according to the present invention, when the garnet single crystal film is deposited on the substrate by the liquid-phase epitaxial method, stress generation in the target single crystal layer can be reduced, and cracking can be prevented.

Although embodiments are described above, the present invention is not limited to these examples. For example, in order to control the ionic valence in garnet and to adjust the lattice constant, small amounts of elements such as Ca, Mg, Zr, and Hf may be added to Ln, and Al, Ga, In, Sc, Ti, Si, Ge, or Sn may be added to A. In this way, the insertion loss can be further reduced by controlling ion valence. Any addition, deletion, or design modification of components as appropriate by those skilled in the art to the aforementioned embodiments, as well as any combination of features of each embodiment as appropriate, are included within the scope of the invention as long as they provide the gist of the invention.

**Claims**

1. A bismuth-substituted rare earth iron garnet single crystal film production method growing a bismuth-substituted rare earth iron garnet single crystal film expressed by the composition formula $(Ln_{3-a}Bi_a)(Fe_{5-b}A_b)O_{12}$ using a substrate of paramagnetic garnet with a lattice constant of Ls, comprising:

   a step of forming a buffer layer with an average lattice constant of Lb (where Lb > Ls) on the surface of the substrate with a thickness of 5 to 30 um; and
   a step of growing a target bismuth-substituted rare earth iron garnet crystal film with an average lattice constant of Lf (where Lf > Lb) with a thickness of 100 $\mu$m or more overlaid on the buffer layer,
   wherein the rate of lattice constant change in the buffer layer is steeper than the rate of lattice constant change in the bismuth-substituted rare earth iron garnet crystal film, and
   wherein in the composition formula, Ln is selected from Y, elements selected from lanthanides (La, Ce, Pr, Nd, Sm, Eu, Gd, Tb, Dy, Ho, Er, Tm, Yb, and Lu), and trace elements selected from Ca, Mg, Zr, and Hf, and A is one or more elements selected from Al, Ga, In, Sc, Ti, Si, Ge, and Sn.

2. The bismuth-substituted rare earth iron garnet single crystal film production method as claimed in claim 1, wherein Lb-Ls is +0.001 to +0.005 Å and Lf-Ls is +0.005 to +0.015 Å at room temperature.

3. The bismuth-substituted rare earth iron garnet single crystal film production method as claimed in claim 1 or 2, wherein the rate of lattice constant change in the buffer layer may be $10 \times 10^{-4}$%/$\mu$m or more.

4. The bismuth-substituted rare earth iron garnet single crystal film production method as claimed in any one of claims 1 to 3, wherein the crystal is grown with a PbO-free melt composition.

5. A Faraday rotator obtained from the bismuth-substituted rare earth iron garnet single crystal film produced by the method as claimed in any one of claims 1 to 4 by polishing and removing the buffer layer.

**6.** An optical isolator comprising the Faraday rotator as claimed in claim 5.

Start

S10

Prepare base substrate

S20

Prepare raw material melt

S30

S31

Buffer layer growth

S32

Target crystal growth

S40

Cutting and polishing process

End

# FIG. 1

**EP 4 177 383 A1**

| **INTERNATIONAL SEARCH REPORT** | International application No. |
|---|---|
| | PCT/JP2021/012963 |

A. CLASSIFICATION OF SUBJECT MATTER
Int.Cl. C30B29/28(2006.01)i, C30B19/04(2006.01)i, G02B27/28(2006.01)i
FI: C30B29/28, C30B19/04, G02B27/28A
According to International Patent Classification (IPC) or to both national classification and IPC

B. FIELDS SEARCHED

Minimum documentation searched (classification system followed by classification symbols)
Int.Cl. C30B29/28, C30B19/04, G02B27/28

Documentation searched other than minimum documentation to the extent that such documents are included in the fields searched
Published examined utility model applications of Japan     1922-1996
Published unexamined utility model applications of Japan    1971-2021
Registered utility model specifications of Japan       1996-2021
Published registered utility model applications of Japan    1994-2021

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 63-270396 A (MATSUSHITA ELECTRIC INDUSTRIAL CO., LTD.) 08 November 1988 (1988-11-08), claims, page 2, upper right column, line 11 to page 3, lower left column, line 12, fig. 1, 2 | 1, 3, 5-6<br>2, 4 |
| Y | WO 2004/070091 A1 (TDK CORPORATION) 19 August 2004 (2004-08-19), paragraphs [0001], [0075]-[0107] | 2 |
| Y | WO 03/000963 A1 (TDK CORP.) 03 January 2003 (2003-01-03), page 1, lines 4-7, page 10, line 24 to page 16, line 1 | 2 |
| Y | WO 2012/086819 A1 (NAMIKI PRECISION JEWEL CO., LTD.) 28 June 2012 (2012-06-28), paragraphs [0001]-[0003], [0014]-[0031] | 4 |
| A | JP 2004-269305 A (TDK CORPORATION) 30 September 2004 (2004-09-30), entire text | 1-6 |
| A | JP 64-72996 A (MATSUSHITA ELECTRIC INDUSTRIAL CO., LTD.) 17 March 1989 (1989-03-17), entire text | 1-6 |

☒ Further documents are listed in the continuation of Box C.     ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 April 2021 | 11 May 2021 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

8

**INTERNATIONAL SEARCH REPORT**

| | International application No. |
|---|---|
| | PCT/JP2021/012963 |

C (Continuation).  DOCUMENTS CONSIDERED TO BE RELEVANT

| Category* | Citation of document, with indication, where appropriate, of the relevant passages | Relevant to claim No. |
|---|---|---|
| A | JP 61-242986 A (MATSUSHITA ELECTRIC INDUSTRIAL CO., LTD.) 29 October 1986 (1986-10-29), entire text | 1-6 |

Form PCT/ISA/210 (second sheet) (January 2015)

**INTERNATIONAL SEARCH REPORT**
Information on patent family members

| | International application No. |
|---|---|
| | PCT/JP2021/012963 |

| | | |
|---|---|---|
| JP 63-270396 A | 08 November 1988 | (Family: none) |
| WO 2004/070091 A1 | 19 August 2004 | US 2006/0150893 A1<br>paragraphs [0001], [0093]-[0108]<br>EP 1595979 A1<br>CN 1768167 A |
| WO 03/000963 A1 | 03 January 2003 | US 2004/0177801 A1<br>paragraphs [0001], [0061]-[0097]<br>EP 1403403 A1<br>KR 10-0552094 B1<br>CN 1547627 A |
| WO 2012/086819 A1 | 28 June 2012 | US 2014/0021418 A1<br>paragraphs [0001]-[0003],<br>[0015]-[0034]<br>CN 103282556 A |
| JP 2004-269305 A | 30 September 2004 | (Family: none) |
| JP 64-72996 A | 17 March 1989 | (Family: none) |
| JP 61-242986 A | 29 October 1986 | (Family: none) |

Form PCT/ISA/210 (patent family annex) (January 2015)

**EP 4 177 383 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000347135 A